# EUROPEAN PATENT APPLICATION

(11) **EP 1 598 312 A1**
(43) Date of publication of application: **23.11.2005**
(21) Application number: 04711478.0
(22) Date of filing: 16.02.2004
(51) Int. Cl.: B81C 1/00, B82B 3/00, H01J 37/317, C23C 16/48

(54) **METHOD FOR FABRICATING THREE-DIMENSIONAL MICROSTRUCTURE BY FIB-CVD AND DRAWING SYSTEM FOR THREE-DIMENSIONAL MICROSTRUCTURE**

(30) Priority: 28.02.2003 JP 2003054361
(71) Applicant: Japan Science and Technology Agency, Kawaguchi-shi, Saitama 332-0012 (JP)
(72) Inventor: HOSHINO, Takayuki, Shibuya-ku, Tokyo 151-0063 (JP); MATSUI, Shinji, Himeji-shi, Hyogo 670-0083 (JP); KONDO, Kazushige, Himeji-shi, Hyogo 671-2201 (JP)
(74) Representative: Hoarton, Lloyd Douglas Charles
(86) International application number: PCT/JP2004/001626
(87) International publication number: WO 2004/076343

(57) **Abstract**

There are provided a fabrication method of a nanostructure by FIB-CVD which enables fabrication of a three-dimensional nanostructure, especially that without a support such as a terrace structure or a hollow structure, and a drawing system thereof.

The three-dimensional nanostructure is fabricated by controlling a focused ion beam to determine a beam irradiation position or time based on discrete drawing data of a multilayer structure generated by calculating a cross-sectional shape divided in a vertical direction of a three-dimensional nanostructure model designed using an electronic microcomputer.

## Description

### TECHNICAL FIELD

The present invention relates to a method for fabricating a three-dimensional (3D) nanostructure by FIB-CVD, wherein the nanostructure having an outer diameter in the order of *µ*m to nm is formed into an arbitrary size, shape, or surface roughness by the CVD method using focused-ion-beam (FIB), and a drawing system thereof.

### BACKGROUND ART

The methods for fabricating the 3D nanostructure by CVD include those using light (laser), focused-electron-beam (FEB), or FIB, in which the 3D structure is fabricated from a deposition vertical to a substrate or tapered in the vertical direction in fabricating such as a diffraction grating or a microlens (see Patent Document 1).

### [Patent Document 1]

Japanese Unexamined Patent Publication No. 2001-107252 (pages 3-4, Fig. 1)

### [Non-Patent Document 1]

Shinji Matsui, Takashi Kaito, Jun-ichi Fujita, Masanori Komuro, Kazuhiro Kanda, Yuichi Haruyama: Three-dimensional nanostructure fabrication by focused-ion-beam chemical vapor deposition, J. Vac. Sci. Tech. B, Vol. 18, No. 6, 2000

### [Non-Patent Document 2]

J. Fujita, M. Ishida, T. Sakamoto, Y. Ochiai, T. Kaito, S. Matsui: Observation and characteristics of mechanical vibration in three-dimensional nanostructures and pillars grown by focused ion beam chemical vapor deposition, J. Vac. Sci. Tech. B, Vol. 19, No. 6, 2001

### [Non-Patent Document 3]

FU Y, Brian NKA; Investigation of integrated diffractive/refractive microlens microfabricated by focused ion beam, Rev. Sci. Ins., Vol. 71, No. 6, pp.2263-2266, 2000

### [Non-Patent Document 4]

FU Y, Brian NKA; A Novel One Step Integration of Edge-Emitting Laser Diode With Micro-Elliptical Lens Using Focused Ion Beam, IEEE Trans. Semi. Manu., Vol. 15, No. 1, pp.2-8, 2002

### [Non-Patent Document 5]

FU Y, Brian NKA, Ong Nan Shing; Integrated Micro-Cylindrical Lens with Laser Diode for Single-Mode Fiber Coupling, IEEE Trans. Pho. Tech. Lett., Vol. 12, No. 9, pp. 1213-1215, 2000

### DISCLOSURE OF THE INVENTION

Although a 2.5-dimensional nanostructure can be fabricated conventionally by irradiating beam on the surface of a substrate using a raster-scan method and controlling scan frequency thereof to control the height of the structure, it has been impossible to fabricate a 3D nanostructure, especially that without a support such as a terrace structure or a hollow structure.

In light of the foregoing circumstances, the present invention is intended to provide a fabrication method of the nanostructure by FIB-CVD which enables the fabrication of the 3D nanostructure, especially that without a support such as a terrace structure or a hollow structure, and a drawing system thereof.

To achieve the above objects, the present invention provides the following:
[1] A method of fabricating a three-dimensional nanostructure by FIB-CVD, wherein a focused ion beam is controlled to determine a beam irradiation position or time based on discrete drawing data of a multilayer structure generated by calculating a cross-sectional shape divided in a vertical direction of a three-dimensional nanostructure model designed using an electronic computer.
[2] The method of fabricating the three-dimensional nanostructure by FIB-CVD according to [1], wherein a height of a layer, surface roughness or a fabrication time of the multilayer structure is controlled by controlling a beam intensity, an irradiation time, or a time interval of irradiation.
[3] The method of fabricating the three-dimensional nanostructure by FIB-CVD according to [1], wherein a hollow structure without a support underneath is fabricated by sorting a drawing order of the discrete drawing data by a condition of whether a supporting layer being present underneath.
[4] The method of fabricating the three-dimensional nanostructure by FIB-CVD according to [1], wherein surface smoothness of the nanostructure due to increased resolution is realized by performing an analog interpolation sequentially for data between digital data points as drawing data.
[5] The method of fabricating the three-dimensional nanostructure by FIB-CVD according to [1], wherein the three-dimensional nanostructure is the three-dimensional nanostructure having a terrace or hollow structure in the *µ*m to nm order.
[6] The method of fabricating the three-dimensional nanostructure by FIB-CVD according to [1] or [5], wherein the three-dimensional nanostructure is a three-dimensionally nanostructured mold.
[7] A drawing system of a three-dimensional nanostructure by FIB-CVD, wherein drawing of a three-dimensionally divided model incorporating a growing mode depending on a spatial drawing position is performed, to realize the free-designed three-dimensional drawing by FIB-CVD using the method of fabricating the three-dimensional nanostructure by FIB-CVD according to [1].

### BRIEF DESCRIPTION OF THE DRAWINGS

Fig. 1 is a schematic diagram illustrating drawing of a 3D nanostructure by a surround-voxel search method according to the present invention;
Fig. 2 is a schematic diagram illustrating a drawing order of the surround-voxel search method according to the present invention;
Fig. 3 is a schematic diagram illustrating drawing of a 3D nanostructure by a supportable-voxel search method according to the present invention;
Fig. 4 is a schematic diagram illustrating a drawing order of the supportable-voxel search method according to the present invention;
Fig. 5 shows a drawn result by the surround-voxel search method according to the present invention;
Fig. 6 shows a drawn result by the supportable-voxel search method according to the present invention;
Fig. 7 is a block diagram of a fabrication apparatus of the 3D nanostructure illustrating an embodiment of the present invention;
Fig. 8 is an SIM image of a compound-eye microlens mold fabricated by a drawing apparatus according to the present invention;
Fig. 9 is an SIM image of a microring with a diameter of approximately 4.2 *µ*m fabricated by the drawing apparatus according to the present invention;
Fig. 10 is an SIM image of the 3D nanostructure (in the shape of a spaceship) fabricated by the drawing apparatus according to the present invention;
Fig. 11 is a schematic diagram describing a point scanning mode of a raster-scan method; and
Fig. 12 is a schematic diagram describing a point scanning mode of a vector-scan method.

### BEST MODE FOR CARRYING OUT THE INVENTION

Embodiments of the present invention will be described in detail hereinbelow.

In the present invention, an arbitrary 3D nanostructure is fabricated by controlling a focused-ion-beam apparatus to determine the irradiation position and time of the focused ion beam based on a 3D model of the 3D nanostructure designed using an electronic computer.

Specifically, cross-sectional shapes of the 3D nanostructure model divided in a vertical direction are firstly calculated to generate discrete drawing data of a multilayer structure. Upon irradiation of the focused ion beam, controlling the beam intensity, the irradiation time, or the time interval of irradiation enables to control the multilayer structure in terms of the height of a layer, the surface roughness of the structure, the fabrication time or the like. In this process, by sorting the drawing order of the discrete drawing data by a condition of "whether a supporting layer is present underneath", a hollow structure without a support underneath may be fabricated.

Hereinafter, drawing search methods for depositing the 3D nanostructure having a hollow shape will be described.

Firstly, the search methods in general are described.

For drawing the 3D structure, the cross-sectional shapes of the drawing target are calculated, the discrete drawing data of the multilayer structure is generated, and the beam is irradiated sequentially to drawing voxel coordinates based on the data. The important factors here are the drawing voxel coordinates (position, overlapping), the dwell time of the beam, the beam intensity, and the drawing order.

Among the 3D structures, those having the hollow or overhang structures especially take the drawing order of the voxels important. Irradiating the beam first to a hollow portion totally does not make sense. Therefore, searching the drawing voxels is required for determining the drawing order in which the hollow portion is drawn later.

In the present invention, two methods, namely "a surround-voxel search method" which searches simply the connection relationship between the drawing voxel and surrounding voxels and "a supportable-voxel search method" which preferentially searches a portion that may serve as a support structure, are proposed and experimented.
(A) Surround-Voxel Search Method (first search method)
   The surround-voxel search method involves searching simply the connection relationship of the target voxel with the surrounding voxels.

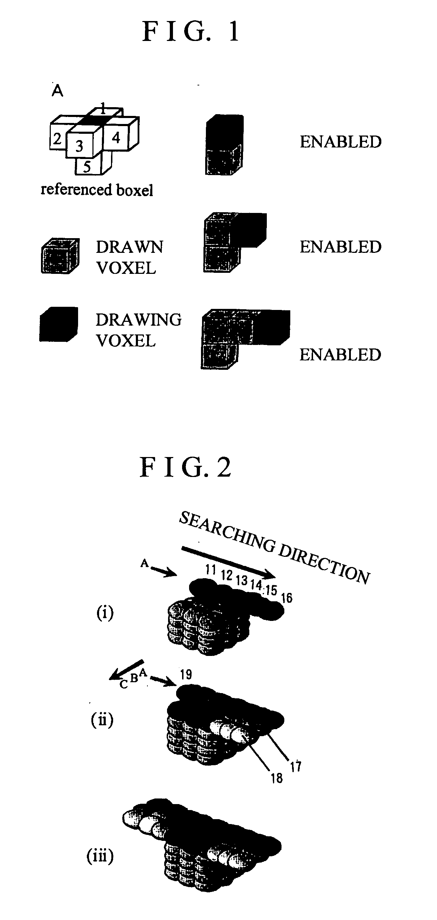

   Fig. 1 is a schematic diagram illustrating drawing of the 3D nanostructure by the surround-voxel search method according to the present invention, and Fig. 2 is a schematic diagram illustrating a drawing order of the surround-voxel search method according to the present invention.
   As shown in Fig. 1, the voxels surrounding the drawing voxel (a gray voxel) A, i.e., the five voxels positioned in front, behind, left, right, and below (voxels 1, 2, 3, 4, and 5) are searched. If a drawn voxel is present in any one of the positions, the drawing voxel in the position is enabled.
   Searching the overhang structure by applying the surround-voxel search method takes the order shown in Fig. 2. That is, as can be seen in Fig. 2, the search proceeds sequentially from the upstream of searching to draw a base portion. In this process, the hollow portion is left undrawn because the drawn voxel is not present in the surrounding five-positions thereof. Next, as shown in Fig. 2(i), when the area having the drawn voxel underneath is searched, the voxels (voxels 11, 12, and 13) on the drawn voxels are enabled. Since the overhang portion in the downstream of searching shown in Fig. 2(i) has the drawn voxel 13 immediately prior thereto, the voxels (voxels 14, 15, and 16) in the portion will be enabled sequentially. Next, as shown in Fig. 2 (ii), the voxel (voxel 19) on the upstream is enabled in the second round of searching. This suggests that the orders and directions of drawing the voxels of the terrace structure are asymmetrical on the upstream and downstream of searching. That is, the terrace structure is extended in the direction parallel to the drawing direction of the base on the upstream of searching, while being extended in the direction perpendicular to the drawing direction of the base on the downstream.
(B) Supportable-Voxel Search Method (second search method)

The supportable-voxel search method involves searching whether the voxel supportable of the drawing voxel is present in the vicinity thereof.

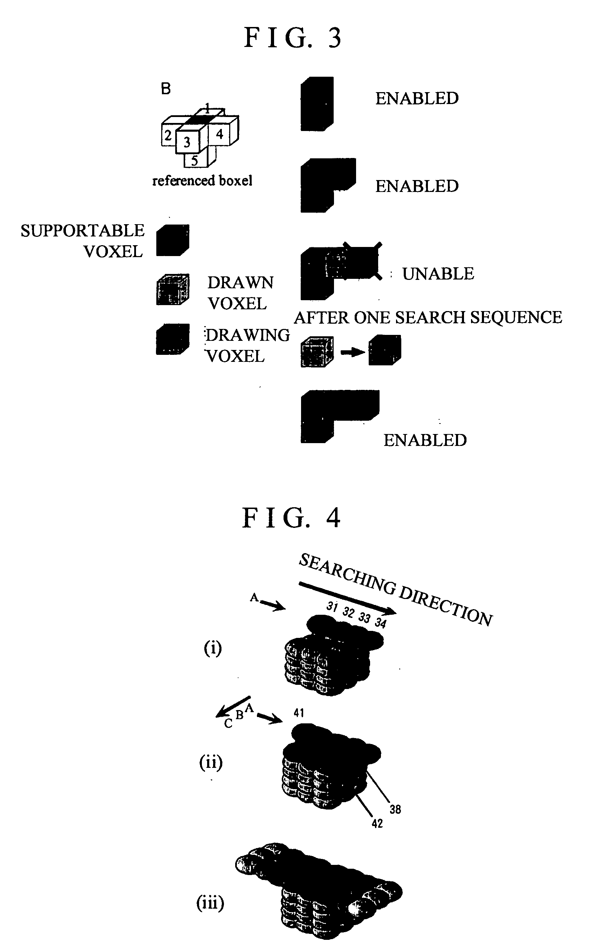

Fig. 3 is a schematic diagram illustrating drawing of the 3D nanostructure by the supportable-voxel search method according to the present invention, and Fig. 4 is a schematic diagram illustrating the drawing order of the supportable-voxel search method according to the present invention.

As shown in Fig. 3, it is searched whether a supportable voxel (gray) is present in the five positions surrounding the drawing voxel B. If the supportable voxel is present in any one of the five positions, the drawing voxel is enabled. The drawn voxel does not simply turn to be the supportable voxel. It is because the supportable voxel has to satisfy certain conditions.

The conditions need to be satisfied are:
(1) The voxel beneath the drawn voxel is the supportable voxel;
(2) A certain cross section has been searced, and there remains no voxel to be enabled.

The result of searching the structure similar to that used in the surround-voxel search method applying the supportable-voxel search method is as shown in Fig. 4. That is, the search starts from the upstream of an arrow indicating the searching direction, as shown in Fig. 4, to draw the base portion. In this process, the overhang portion on the upstream is left undrawn because the portion has no supporting base in the vicinity thereof. The area having the base (voxels 31, 32, and 33) is enabled. On the downstream, only voxel 34 adjacent to the supportable voxel is enabled. Succeeding area will not be enabled until voxel 34 turns to be the supportable voxel. Next, as shown in Fig. 4(ii), the voxel (voxel 42) on the upstream is enabled in the second round of searching. As a result, the overhang portion is drawn in the direction parallel to the base and extending outwardly. The similar orders and directions of drawing are applied on the upstream and downstream of searching.

Hereinafter, deposition results in accordance with the foregoing methods are described.

### [Deposition Result of Surround-Voxel Search Method (first search method)]

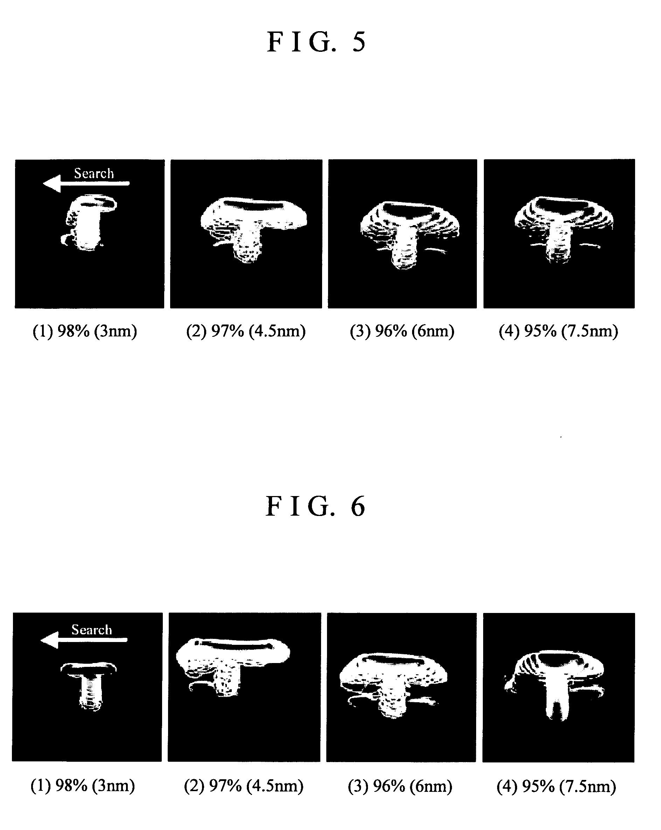

Fig. 5 shows a drawn result by the surround-voxel search method according to the present invention.

As shown in Fig. 5, the drawing is performed by applying the surround-voxel search method to a 3D drawing apparatus. The drawing density is represented by overlapping (%) of the diameter on the basis of the effective deposition diameter (that is, the pillar diameter). For example, when the beam is overlapped by 98%, the irradiation pitch is 3 nm. The searching direction is from the right to the left on the paper. As the irradiation pitch is made narrower from 95% to 98%, the deposition on the substrate on the upstream of searching (the right side) becomes less, resulting in the better condition. However, the deposition on the substrate or the side surface of the pillar is still found on the downstream of searching (the left side). It is apparently because of the asymmetrical characteristics of the directions and orders of drawing on the upstream and downstream, as described above.

From these results, it is understood that the method of "extending the terrace gradually from the base" which is the drawing method on the upstream is easier to perform than the method of "extending linearly in the midair" on the downstream.

### [Deposition Result of Supportable-Voxel Search Method (second search method)]

Fig. 6 shows a drawn result by the supportable-voxel search method according to the present invention.

Fig. 6 shows the result using the similar method to that applied in Fig. 5 by changing the drawing pitch from 95% to 98%. While the upstream of searching exhibits good result with less deposition on the substrate when the irradiation pitch is narrowed from 95% to 98%, the both sides exhibit similar deposition results with substantially no deposition on the substrate or the side surface of the pillar at the irradiation pitch of 98%. The symmetric characteristics of the direction and order of drawing of the supportable-voxel search method are apparently brought out. However, it is understood that the upstream exhibits the better deposition result. It does not depend on the difference in the amount of gas flow, examined by exchanging the X- and Y-axes.

Moreover, there exhibits the drawing deficiencies, e.g., the scale-like shape on the side surface of the pillar or the ridge-like shape on the bottom of the hollow portion in the drawing pitch of 97%, while the drawing result is very good in the pitch of 98%. The drawing result gradually becomes better as the pitch is narrowed from 95%. Such differences in the deposition in the hollow portion within a few nanometers support the possibility of the drawing control in the order of nanometer. Changing the overlapping from 97% to 98% means narrowing the drawing pitch by 1.5 nm. Considering that the growing point is made into contact by changing the pitch by 1.5 nm, the diameter of the growing point with the dwell time of 100 *µ*m is several nanometers. Considering that the beam diameter of FIB used here is 7 nm, the deposition is controlled more precisely than the beam diameter.

Hereinafter, embodiments of the present invention will be described.

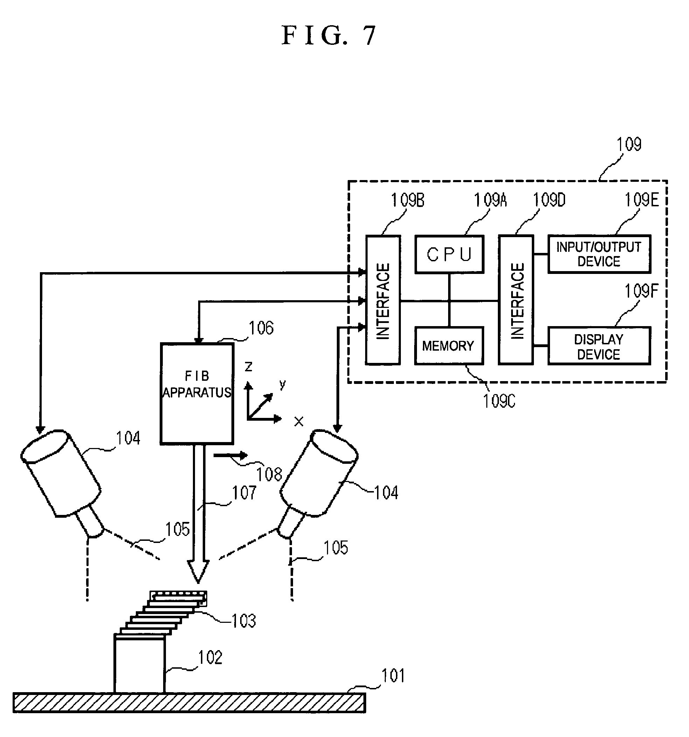

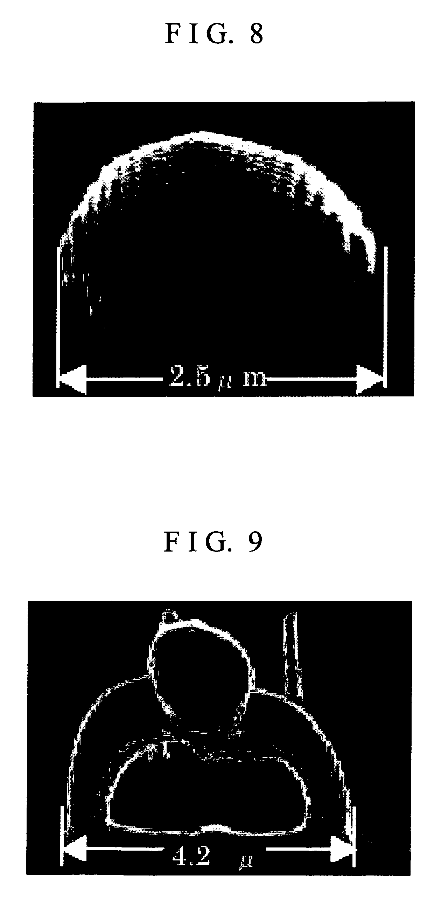

Fig. 7 is a block diagram of a fabrication apparatus of the 3D nanostructure illustrating the embodiment of the present invention, Fig. 8 is an SIM image of a compound-eye microlens mold fabricated by a drawing apparatus illustrating the embodiment of the present invention, Fig. 9 is an SIM image of a microring with a diameter of approximately 4.2 *µ*m.

In Fig. 7, reference numeral 101 denotes an Si substrate, 102 denotes a DLC (Diamond Like Carbon) pillar as a deposition structure, 103 denotes the 3D nanostructure formed on the DLC pillar 102, 104 denotes a gas nozzle to inject phenanthrene gas (a melting point: 99 °C, a boiling point: 340 °C) as a reaction gas, 105 denotes the phenanthrene gas, 106 denotes an FIB apparatus, 107 denotes the FIB, 108 denotes a scanning direction of the FIB 107, and 109 denotes a computer-controlled drawing device, which is provided with a CPU (Central Processing Unit) 109A, interfaces 109B and 109D, a memory 109C prestoring 3D positional data, a beam irradiation position, an irradiation direction and an irradiation time, an input/output device 109E, and a display device 109F.

In the present invention, the arbitrary 3D structure can be fabricated using the focused ion beam (FIB). The arbitrary 3D structure was fabricated by converting a surface model created by a 3D-CAD into scan data, followed by drawing the structure discretely using FIB-CVD. In this process, the amount of deposition is controlled by changing the dwell time, the amount of the beam current, or a drawing interval of the ion beam 107 irradiated on the substrate 101. For drawing a free-designed shape, it is necessary to fabricate the overhang or inversely-tapered structure. Therefore, the drawing apparatus of the present invention targets on fabricating the 3D structure having the overhang shape as the end goal, that can be achieved using a vector-scan method. In the experiment, a 3D-DLC structure was fabricated by irradiating the Ga⁺ ion beam 107 on the Si substrate 101 in the phenanthrene gas 105 atmosphere.

Fig. 8 is the SIM image of the compound-eye microlens mold fabricated using the drawing apparatus of the present invention. The lens takes a semi-spherical shape with about 2.5 *µ*m in diameter and about 0.8 *µ*m in height. Fig. 9 is the SIM image of the microring with about 4.2 *µ*m in diameter, wherein the overhang structure can be fabricated. The surface roughness of the 3D structure can be controlled at the nm level by changing the drawing interval.

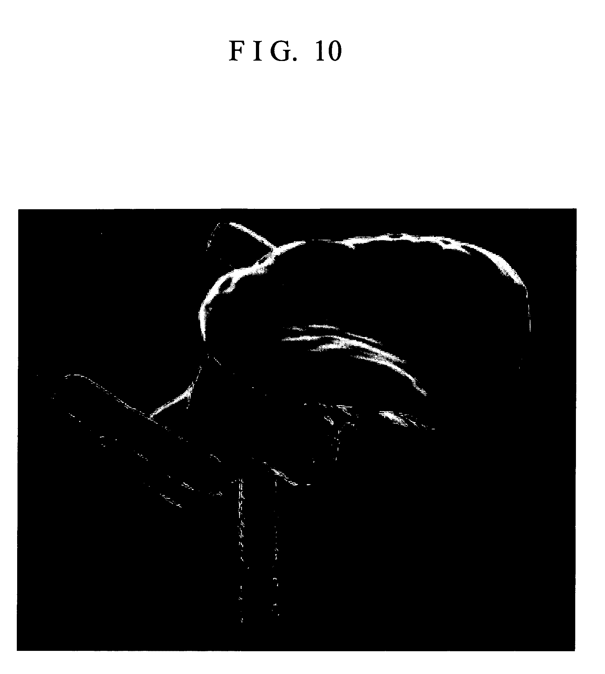

Fig. 10 is the SIM image illustrating the 3D nanostructure (spaceship shape) fabricated using the drawing apparatus of the present invention.

As shown in this figure, the 3D nanostructure of the spaceship shape is formed by fabricating the pillar structure with a diameter of about 0.8 *µ*m using the phenanthrene gas irradiated on the Si substrate, followed by fabricating a horizontal plate structure. And then, the overhang structure having a disc-like shape with a diameter of about 8 *µ*m is fabricated. The fabrication condition was: a 30 kV Ga⁺ ion beam, the beam current of about 10 pA, and the fabrication time of about 1 hour.

Moreover, while the 3D structure is fabricated based on the discrete drawing data obtained from the 3D model of the nanostructure, as described above, the drawing data of the structure is indicated by the digital points and thus the surface roughness of the 3D structure formed by FIB-CVD depends on the resolution of a digital-analog converter (D/A converter). Therefore, to realize the surface smoothness of the 3D structure by increasing the resolution, an analog interpolation is performed sequentially for the data between the digital data points. That is, in the drawing method of the 3D structure according to the present invention, it is preferable to realize the surface smoothness of the 3D structure using the analog interpolation method to perform the analog interpolation between the points drawn by the 3D digital drawing method.

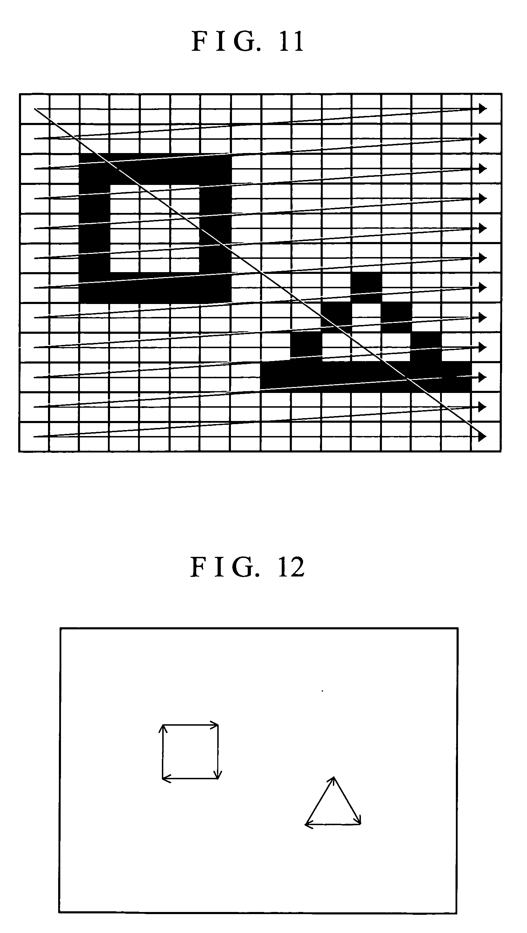

More specifically, there is a raster-scan method shown in Fig. 11, for example. Although this is the common scanning method which scans every point, it takes time to fabricate the structure due to the method requiring to scan every point. Since it is important to fabricate the structure in a short time when fabricated by FIB, the raster-scan method is not preferable.

The vector-scan method, as shown in Fig. 12, can reduce the time to fabricate the structure because the method only requires scanning the drawing points. The present invention applies the vector-scan method as the basic method for the drawing system.

In the conventional methods, the resolution and the surface roughness of the structure are determined based on the D/A conversion resolution regardless of which of the foregoing methods being used. Therefore, the present invention applies the method to sequentially interpolate the data between the discrete drawing points. By the interpolation method, the resolution higher than that of the D/A converter can be realized to improve the surface smoothness. While the method using only the D/A converter can be referred to as a digital drawing method, the method which can perform the analog interpolation of the data, i.e., the analog interpolation method, is applied herein.

Moreover, the 3D structure obtained by the method of the present invention is characterized by being the 3D structure having the terrace or hollow structure in the *µ*m to nm order. Specifically, the 3D nanostructured mold can be an example of the 3D nanostructure having the hollow structure. Furthermore, a 3D microcube mold without the hollow structure can be fabricated.

While the present invention is not limited to the foregoing embodiments, various modifications can be made according to the purpose of the present invention and are not excluded from the scope of the present invention.

As described above in detail, in the present invention, the 3D nanostructure including the terrace or hollow structure in the *µ*m to nm order can be fabricated with the arbitrary size, shape, and surface roughness. Therefore, micro optical elements such as the microlens, micro mechanical elements such as nanotweezers, or a microsystem can be fabricated.

### INDUSTRIAL APPLICABILITY

The fabrication method of the 3D nanostructure and the drawing system of the 3D nanostructure by FIB-CVD according to the present invention are suitable for the 3D nanostructure or a fabrication tool of the 3D nanostructured mold which enables the fabrication of the 3D nanostructure having the terrace or hollow structure in the *µ*m or nm order with the arbitrary size, shape, or surface roughness.

## Claims

1. A method of fabricating a three-dimensional nanostructure by FIB-CVD, wherein a focused ion beam is controlled to determine a beam irradiation position or time based on discrete drawing data of a multilayer structure generated by calculating a cross-sectional shape divided in a vertical direction of a three-dimensional nanostructure model designed using an electronic computer.

2. The method of fabricating the three-dimensional nanostructure by FIB-CVD according to Claim 1, wherein a height of a layer, surface roughness or a fabrication time of the multilayer structure is controlled by controlling a beam intensity, an irradiation time, or a time interval of irradiation.

3. The method of fabricating the three-dimensional nanostructure by FIB-CVD according to Claim 1, wherein a hollow structure without a support underneath is fabricated by sorting a drawing order of the discrete drawing data by a condition of whether a supporting layer being present underneath.

4. The method of fabricating the three-dimensional nanostructure by FIB-CVD according to Claim 1, wherein surface smoothness of the nanostructure due to increased resolution is realized by performing an analog interpolation sequentially for data between digital data points as drawing data.

5. The method of fabricating the three-dimensional nanostructure by FIB-CVD according to Claim 1, wherein the three-dimensional nanostructure is the three-dimensional nanostructure having a terrace or hollow structure in the *µ*m to nm order.

6. The method of fabricating the three-dimensional nanostructure by FIB-CVD according to Claim 1 or 5, wherein the three-dimensional nanostructure is a three-dimensionally nanostructured mold.

7. A drawing system of a three-dimensional nanostructure by FIB-CVD, wherein drawing of a three-dimensionally divided model incorporating a growing mode depending on a spatial drawing position is performed, to realize the free-designed three-dimensional drawing by FIB-CVD using the method of fabricating the three-dimensional nanostructure by FIB-CVD according to Claim 1.
